# EUROPEAN PATENT APPLICATION

(11) **EP 1 271 776 A2**
(43) Date of publication of application: **02.01.2003**
(21) Application number: 02012525.8
(22) Date of filing: 05.06.2002
(51) Int. Cl.: H03H 11/20

(54) **Method and device to phase shift low distortion electrical signals**

(30) Priority: 29.06.2001 IT MI20011375
(71) Applicant: Siemens Information and Communication Networks S.p.A., 20126 Milano (IT)
(72) Inventor: Bonato, Paolo, 20156 Milano (IT); Fusaroli, Stefano, 20040 Cavenago Brianza (IT)
(74) Representative: Giustini, Delio

(57) **Abstract**

In addition to a local oscillator first signal (fol), it is generated a local oscillator second signal (fol') derived from said first signal but phase shifted of a selectively determined phase shifting value (φ). The input signal (f1) and the local oscillator first signal (fol) are mixed (2) between them and the beating signal so obtained is filtered (8) to select one of the components of the beating signal included between the component at sum frequency (fol+f1) and the component at difference frequency (fol-f1) of the signals subjected to beating. The selected component is submitted to mixing (9) with the local oscillator second signal (fol') so to generate a second beating signal. This last signal is filtered in turn to extract the component corresponding to the frequency of the input signal (f1). The component of the second beating signal so extracted (f1') represents a replica of the input signal (f1) duly phase shifted of the above mentioned phase shifting value (φ).

## Description

### Field of the Invention

The present invention relates to the techniques that can be used to phase shift electrical signals.

The invention has been developed with particular attention to the possible application in the frame of telecommunication systems, for instance to implement phase shifting functions in the frame of systems employing space diversity reception techniques and/or systems with multilevel modulation such as for instance 64, 128 or 256 TCM (Trellis Code Modulation).

These systems require very high transmission qualities, among which linearity (intended as virtual absence of distortion) plays a fundamental role. For this reason, phase shifting devices directly acting on the signal submitted to phase shifting and such to indefinitely control the phase cannot be generally employed in this context. In fact, these systems end up by introducing distortions or an unacceptable noise level in the signal: for instance, a classic modulator I and Q, when directly used on the signal submitted to phase shifting, usually generates inter-modulation products of the third order at 25-35 dBc level.

### Background art

For this reason it has already been tried out the resort to systems operating in indirect mode through signal conversion implemented by means of a local oscillator that can be phase shifted, for instance availing of a unit with phase shifter function placed in cascade to the local oscillator of the signal reception converter.

Another traditional setting foresees the recourse to microwave phase shifters, employing for instance a phase shifter calibrated on one fourth of range. Apart from any other consideration, resort to a microwave solution results penalized by high testing and functional test costs.

In any case, these known solutions encounter with the intrinsic difficulty to pursue the integration with transmission/reception circuits operating at intermediate frequency (IF) to which the phase shifter shall generally be associated.

### Object and summary of the invention

Scope of the present invention is therefore to supply an improved solution enabling to continuously phase shift a signal (such as for instance a multilevel modulated signal brought at intermediate frequency), that is, without limitations of the range of phase shifting values that can be obtained, both at total extension level of this range, and concerning the resolution of phase shifting values that can be used, that one wants to select without limitation matching any desired value. All the above without introducing distortions, noise and without having to change the intermediate frequency, with the ensuing possibility to implement a phase shifter to be used where there is the need to control the phase of a signal like a modulated signal obtaining advantages either from the functional point of view, and in terms of setting-up, testing and test costs, having in addition the possibility to easily obtain the integration with the circuits which the phase shifter shall be associated to.

According to the present invention, this object is reached thanks to a procedure having the characteristics specifically recalled in the appended claims. The invention refers also to the corresponding phase shifting device.

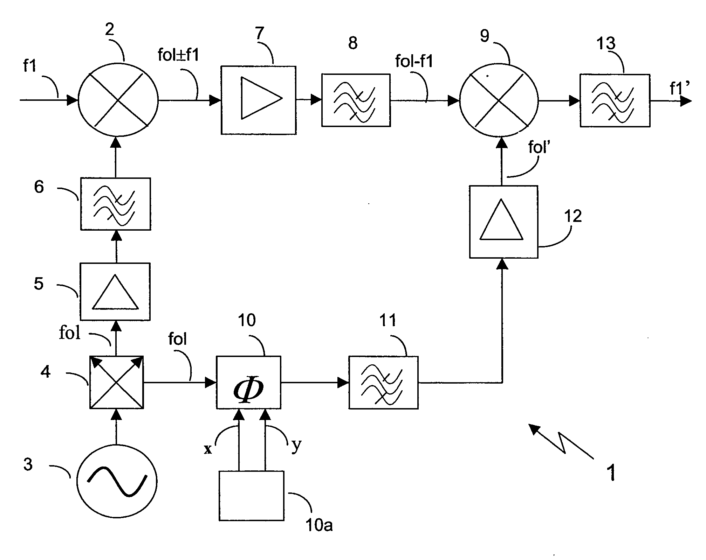

### Brief description of the figure

The invention may be better understood with reference to the following detailed description, taken in conjunction with the accompanying drawings. The drawings include a unique figure representing as block diagram the possible structure of a phase shifter device according to the invention.

### Detailed description of a preferred embodiment of the invention

In particular, the diagram shown in the figure of the attached drawings, corresponds to a circuit implemented on an ordinary fibreglass reinforced plastic support of the type generally used to make printed circuits of the traditional type, usually defined FR4.

In this way the phase shifting circuit according to the invention can be integrated in a unique plate with other functions of a corresponding receiver consisting of a diversity HCDR receiver.

The circuit shown can be completely software controlled by the unit enclosing the circuit itself. The connections shown are in strip line technology with shielding cells obtained on the cover and filters in SMT technology (Surface Mounting Technology) placed on the supply of each component.

In particular, the described solution corresponds to a circuit, globally indicated with 1, susceptible of continuously phase shifting, endless and with high linearity (therefore, with low distortion) a multilevel modulated radio frequency signal.

As an example, it can be an input signal f1 consisting of a 70 MHz carrier, modulated with a modulating signal having band width in the range of 30 MHz.

In the attached drawing, the numeric reference 2 indicates a first mixer (known in itself) in which the input signal at frequency f1 is submitted to mixing (and therefore caused to "beat") with a sinusoidal signal having fol frequency equal, for instance, to 310 MHz.

The sector skilled technicians could immediately appreciate that the numeric values here indicated are given as an example only and therefore the same have not to be construed as a restriction of the capacity of the invention.

The signal with fol frequency is obtained starting from a local oscillator 3 letting it transit through an element having splitter functions 4 (whose function shall be better described later on), an amplifier 5 and a filter 6, destined to give the fol signal high spectral purity characteristics.

In the currently preferred embodiment of the invention, the amplifier 5 (as well as the other amplifiers reference to which shall be made later on) is preferably equipped with an input stage - not explicitly shown in the drawings, but of the known type - with band pass filter characteristics. Said input stage may perform a purification function of the spurious frequency components of the signal crossing the subject the amplifier.

The result of the beating action occurring in the mixer 2 is, as it is well known, the formation of a signal showing the same spectral characteristics of the signal at frequency f₁ reproduced in duplicate way around carrier frequencies corresponding to the sum frequency (fol + f1) and to the difference frequency (fol - f1) of the signals allowed to mix in the mixer 2.

Therefore, assuming that the signal f1 (for description simplicity sake, the different signals considered shall be identifier later on with the corresponding frequencies) is a modulated signal (having for instance the characteristics previously recalled) centred around a frequency equal, for instance, to 70 MHz, and that the fol signal is a sinusoidal signal (mono frequency) at a frequency equal, for instance, to 310 Mhz, the above mentioned sum and difference frequencies result equal to 380 MHz and 240 MHz, respectively.

As already said, the indication of particular frequency values shall in no way be construed as a limitation of the invention importance. The experiences made by the Applicant have however proved that the choice of a value generically different from a multiple of the frequency f1 for the fol frequency, has to be preferred. In other words, we shall preferably have fo1≠kf1.

After letting it transit through an amplifier 7 (it too preferably fit with an input stage with rejection characteristics of the spurious harmonic components), the signal obtained by beating in mixer 2 is sent towards a band pass filter 8. The function of filter 8 is to eliminate one of the image components from the spectrum of the signal obtained through beating.

In the example of the embodiment herein described (and we recall it is an example) the filter 8 is implemented - in a known way in itself - in such a way as to eliminate the image spectrum centred around the sum frequency fo1+f1 (at 380 MHz, in the example shown) from the signal obtained by beating.

In other words, at the output of filter 8 the sole component at fol frequency-f1 is present (equal to 240 MHz, in thee example shown).

Those skilled in the art could however appreciate - also from the following description - that this choice is not at all imperative to the purposes of the operation of the device described. In other words, the filter 8 could be made in such a way as to eliminate the component at the difference frequency and let the signal pass at the sum frequency fol+f1.

Irrespective of the specific choice adopted to this purpose, the signal at output of filter 8 is sent to the input of an additional mixer 9 (it too of the known type) in which the above mentioned fol signal - f1 is submitted to beating with a replica fol' duly phase shifted, derived it too from the splitter module 4, of the fol signal.

To this purpose, the fol signal - hereinafter defined local oscillator "first" signal - is transferred towards the mixer 9 through a chain including a phase shifter 10, a band pass filter 11 and an amplifier 12. At the output of this chain the fol' signal is present - hereinafter defined also local oscillator "second" signal.

The phase shifter 10 preferably consists of a standard modulator I and Q available on the market. For instance, in the production of the company Hewlett Packard (now Agilent) a modulator of this type is available, having the capacity to modulate with 35 dBc rejection of local oscillator and lateral band employing a carrier up to 500 MHz.

The phase shifting value assigned to the fol signal by the phase shifter 10 can be checked acting (according to the known criteria that do not require being here described, also because in itself not important to the purposes of the understanding of the invention) on the relevant inputs currently defined x and y. This can occur, for instance, through a microprocessor control unit 10a that may be easily integrated, together with the remaining portion of device 1 here described, in a processing stage of the signals at intermediate frequency, such as the signals whose frequency values have been previously recalled.

The filter 11 is an additional band pass filter whose function is to remove the spurious spectral components from the output signal of the phase shifter 10 letting the component pass at the fol frequency destined to be transferred to the mixer 9 through the amplifier 12. Preferably, also the amplifier 12, as the amplifiers 3 and 6, shows a relevant input stage with rejection characteristics of the undesired harmonic components.

It could be appreciated that the arrangement of the amplifier 12 in cascade to the filter 11 (that is, with the filter 11 placed right at the phase shifter output 10), though preferred, is not mandatory to the purposes of the implementation of the invention. Therefore, the filter 11 could be placed in cascade to the amplifier 12, the same considerations essentially applying also to the cascades made of the amplifiers 5 and 7 and of filters 6 and 8.

The result of the mixing action made in the mixer 9 is to originate an additional beating signal that, as it is well known, includes both a component centred to the sum frequency of the frequencies mixed (in this case, fol+fol+f1 that is 2fol-f1), and to the difference frequency (in this case, fo1-fol-f1, or simply f1).

An additional band pass filter 13 takes care to eliminate the component at the sum frequency from the beating signal generated in the mixer 12. At the output of filter 13 a replica f1' of the signal f1 is present, which due to the way it was generated carries a phase shifting component φ compared to the signal f1 phase at input. The value of said phase shifting φ corresponds to the phase shifting value applied by the phase shifter 10 to the fol signal to obtain the fol' signal.

In other words, assuming that the signal f₁ is equivalent in general to an expression of the type cosω₀₁t, an expression of the cos(ω₀₁t+φ) type applies to the output signal f1'.

It could be appreciated that a similar result can be obtained also if the filter 8 is implemented in such a way to allow passing of the component of the beating signal obtained in the mixer 2 with frequency corresponding to the sum frequency of the frequencies caused to beat, instead of the difference component.

The circuit 1 just described shows two branches relevant to the oscillator path and one relevant to the path after the first conversion. If the delay introduced in the branches including the amplifier 5, the filter 6, the amplifier 7 and the filter 8 perfectly equals the delay tied to the branch including the phase shifter 10, the filter 11 as well as the amplifier 12, the signal f1' at the output is not affected by phase noise and possible frequency jumps (jump) of the local oscillator 3 in the same frequency band.

All the above for an evident cancellation effect, that greatly facilitates the implementation of the device 1: the accuracy of the local oscillator frequency 3 results in fact largely negligible on the device performances, the same considerations applying in essence also to the spectral purity (phase noise). Moreover, the described solution does not require dampers and suspensions.

As already said, the selection of the local frequency fol is preferably made in order to manage that the product of the first conversion is not a multiple of the frequency f1: this to avoid superimposition of the signal with one of its harmonics.

It is also important to filter all the conversion products of higher rank and possible spurious couplings on the oscillators before performing the conversions. This is made through low pass filters, not specifically shown in the figures, but of the known type.

It is also important the correct implementation of the band pass filters 8 and 13.

The first one shall in fact suppress the residual of local oscillator (typically 40 dB minimum) and the lateral band higher than the sum frequency (380 MHz in the example shown), preferably 50 dB minimum. In fact, the latter could be reconverted to 70 MHz phase shifted by φ and originate a signal width modulation at output as the phase varies, with an index depending on the suppression degree.

For the amplifiers placed in cascade to the modulated signal (for instance the amplifier 7) it is preferred the choice of high IP amplifiers (34 dBm). For the other amplifiers (5 and 12) placed in the branches of local oscillator generic amplifiers can be used, having average capacity (for instance 18 dBm).

For the implementation of the local oscillator 3, the experiences made by the Applicant were based on the use of a low cost surface acoustic wave resonator (Surface Acoustic Wave or SAW), so to avoid the control of the oscillator frequency and the implementation of wider but more selective filters.

According to these choices, phase shifters could be implemented according to the invention having an inter modulation product of the third order or IM3 higher than 70 dBc with output power Pₒᵤₜ=-13 dBm (operation standard level), ND = 15 dB; G= 0dB and return loss IN/OUT ≥ 10 dB (50 Ohm).

It is evident that variants and modifications are possible for a field technician without departing from protection of the following claims.

As an example (and, of course without the intent of restricting the capacity of the invention), the function to generate the local oscillator signal, either in the fol version destined to be sent towards the mixer 2 (local oscillator first signal) or in the fol' phase shifted version destined to be sent towards the mixer 9 (local oscillator second signal), could be assigned to a digital oscillator generating the two wave forms starting from stored samples of a sinusoidal wave form with the possibility to selectively vary the phase shifting among the samples used for the generation of either signal.

## Claims

1. Method to generate, starting from an electrical input signal (f1), an output signal (f1') phase shifted versus said input signal (f1) of a selectively determined phase shifting value (φ), **characterized in that** it includes the operations:
- generating (3 to 6) a local oscillator first signal (fol),
- generating (3 a 12) a local oscillator second signal (fol') at the same frequency and coherent with said first signal local oscillator (fol); said local oscillator second signal (fol') being phase shifted, compared to said local oscillator first signal (fol), of a phase shifting value corresponding to said selectively determined phase shifting value (φ),
- submitting to mixing (2) said input signal (f1) and said local oscillator first signal (fol), so to generate a first beating signal,
- filtering (13) said first beating signal so to select one of the components of said first beating signal included between the component at the sum frequency and the component at the difference frequency of the signals submitted to mixing,
- submitging said one selected component to mixing (9) with said local oscillator second signal (fol'), so to generate a second beating signal, and
- filtering said second beating signal so to select the component corresponding to the frequency of said input signal (f1), the component of said second beating signal so selected forming said output signal (f1').

2. Method according to claim 1, **characterized in that** it includes the operation to generate said local oscillator first signal (fol) and said local oscillator second signal (fol') at a frequency different from a multiple of the frequency of said input signal (f1).

3. Method according to claim 1 or claim 2, **characterized in that** said input signal (f1) is a signal at intermediate frequency (IF).

4. Method according to any claim 1 to 3, **characterized in that** it includes the operation to generate said local oscillator first signal (fol) and said local oscillator second signal (fol') as signals at intermediate frequency (IF).

5. Method according to any of the previous claims, **characterized in that** it includes the operation to generate said local oscillator second signal (fol') through a modulator of the I and Q type (10).

6. Method according to any of the previous claims, **characterized in that** it includes the operation to submit at least one between said local oscillator first signal (fol) and said local oscillator second signal (fol') to a band pass filtering (6, 11) with the suppression of spurious harmonic components.

7. Method according to claim 5 and claim 6, **characterized in that**, with reference to said local oscillator second signal (fol'), said filtering operation (11) is made at the output of said modulator I and Q (10).

8. Device to generate, starting from an input electrical signal (f1) an output signal (fi') phase shifted versus said input signal (f1) of a selectively determined phase shifting (φ) value, **characterized in that** it includes:
- a generator (3 a 6; 10 a 12) to generate a local oscillator first signal (fol) and a local oscillator second signal (fol') at the same frequency of said local oscillator first signal (fol); said local oscillator second signal (fol') being phase shifted, compared to said local oscillator first signal (fol) of a phase shifting value equal to said phase shifting value selectively determined (φ),
- a first mixer (2) to mix said input signal (f1) and said local oscillator first signal (fol) so to generate a first beating signal,
- a first filter (8) to filter said first beating signal so to select one of the components of said first beating signal included between the component at the sum frequency and the component at the difference frequency of the signals submitted to mixing,
- a second mixer (9) to mix said one selected component with said local oscillator second signal (fol') so to generate a second beating signal, and
- a second filter (13) to filter said second beating signal so to select the component corresponding to the frequency of said input signal (f1), the component of said second beating signal so selected forming said output signal (f1').

9. Device according to claim 8, **characterized in that** said generator (3 to 6; 10 to 12) is configured to generate said local oscillator first signal (fol) and said local oscillator second signal (fol') at a frequency different from a multiple of the frequency of said input signal (f1).

10. Device according to claim 8 or claim 9, **characterized in that** said first mixer (2) is configured to mix, as said input signal (f1), a signal at intermediate frequency (IF).

11. Device according to any claim 8 to 10, **characterized in that** said generator (3 to 6; 10 to 12) is configured to generate said local oscillator first signal (fol) and said local oscillator second signal (fol') are signals at intermediate frequency (IF).

12. Device according to any of the previous claims 8 to 11, **characterized in that** said generator (3 to 6; 10 to 12) includes a modulator of the I and Q type (10) to phase shift said local oscillator second signal (fol').

13. Device according to any of the previous claims 8 to 12, **characterized in that** it includes at least one filter (6, 11) to submit at least one of said local oscillator first signal (fol) and said local oscillator second signal (fol') to a band pass filtering with the suppression of the spurious harmonic components.

14. Device according to claim 12 and claim 13, **characterized in that** it includes a band pass filter (11) placed at the output of said modulator I and Q (10).

15. Device according to any claim 8 to 14, **characterized in that** it is made on a fibreglass reinforced plastic support called also FR4.
